# EUROPEAN PATENT APPLICATION

(11) **EP 4 661 072 A1**
(43) Date of publication of application: **10.12.2025**
(21) Application number: 24819450.8
(22) Date of filing: 11.03.2024
(51) Int. Cl.: H01L 23/00, H01L 21/683, H01L 21/673, B23K 26/36, H01L 25/075

(54) **TRANSFER SUBSTRATE AND LIGHT EMITTING DIODE TRANSFER METHOD USING SAME**

(30) Priority: 09.06.2023 KR 20230074218
(71) Applicant: Samsung Electronics Co., Ltd., Suwon-si, Gyeonggi-do 16677 (KR)
(72) Inventor: CHOI, Wonsik, Suwon-si Gyeonggi-do 16677 (KR); KIM, Byungchul, Suwon-si Gyeonggi-do 16677 (KR); LEE, Yoonsuk, Suwon-si Gyeonggi-do 16677 (KR); LEE, Mingyu, Suwon-si Gyeonggi-do 16677 (KR); HAN, Seungryong, Suwon-si Gyeonggi-do 16677 (KR)
(74) Representative: Appleyard Lees IP LLP
(86) International application number: PCT/KR2024/003081
(87) International publication number: WO 2024/253298

(57) **Abstract**

A transfer substrate for a light emitting diode is disclosed. The transfer substrate includes: a substrate; a laser ablation layer provided on the substrate; and an adhesive layer provided on the laser ablation layer and having a plurality of light emitting diodes attached thereto, wherein the laser ablation layer and the adhesive layer are divided into a plurality of portions corresponding to the plurality of light emitting diodes.

## Description

### [TECHNICAL FIELD]

The disclosure relates to a transfer substrate and a light emitting diode transfer method using the same.

### [BACKGROUND ART]

The display panel includes a thin film transistor (TFT) substrate including a plurality of TFTs and a plurality of light emitting diodes (LEDs) mounted on a substrate. The plurality of LEDs may be inorganic LEDs that emit light by itself. The plurality of LEDs are operated in units of pixels or sub-pixels and express various colors. Operations of each pixel or subpixel are controlled by a plurality of TFTs. Each LED emits various colors, e.g., red, green, or blue. The plurality of LEDs may be transferred from a wafer or a relay substrate to a TFT substrate by a pick and place transfer scheme, a stamping transfer scheme, or a laser transfer scheme.

### [DISCLOSURE]

### [TECHNICAL SOLUTION]

According to an aspect of the disclosure, there is a transfer substrate including: a substrate; a laser ablation layer provided on the substrate; and an adhesive layer provided on the laser ablation layer and including a plurality of light emitting diodes, and the laser ablation layer and the adhesive layer are divided into a plurality of portions each including ones of the plurality of light emitting diodes.

The substrate may be configured to transmit a laser beam.

According to an aspect of the disclosure, there is a light emitting diode transfer method including: transferring a plurality of light emitting diodes from a wafer to a first transfer substrate on which a first laser ablation layer and a first adhesive layer are stacked; removing first exposed portions of the first laser ablation layer and the first adhesive layer, the first exposed portions being exposed between the plurality of light emitting diodes; transferring the plurality of light emitting diodes from the first transfer substrate to a second transfer substrate on which a second laser ablation layer and a second adhesive layer are stacked; removing second exposed portions of the second laser ablation layer and the second adhesive layer, the second exposed portions being exposed between the plurality of light emitting diodes; and transferring the plurality of light emitting diodes from the second transfer substrate to a target substrate.

Removing the first exposed portions of the first laser ablation layer and the first adhesive layer exposed between the plurality of light emitting diodes may include removing the first exposed portions by a plasma etching process.

Removing the second exposed portions of the second laser ablation layer and the second adhesive layer exposed between the plurality of light emitting diodes may include removing the second exposed portions by a plasma etching process.

Removing the first exposed portions of the first laser ablation layer and the first adhesive layer may include removing the first layer ablation layer by laser beam and removing the first adhesive layer by a plasma etching process.

Removing the second exposed portions of the second laser ablation layer and the second adhesive layer may include removing the second laser ablation layer by laser beam and removing the second adhesive layer by a plasma etching process.

The plurality of light emitting diodes transferred from the first transfer substrate to the second transfer substrate may be arranged with a first distance between each other in a first direction.

The plurality of light emitting diodes transferred from the first transfer substrate to the second transfer substrate may be arranged in a grid in the second transfer substrate, and the grid may include a plurality of rows and a predetermined interval between each of the plurality of rows.

The plurality of light emitting diodes transferred from the second transfer substrate to the target transfer substrate may be arranged in a grid in the target transfer substrate, and wherein the grid may include a plurality of columns and a predetermined interval between each of the columns.

According to an aspect of the disclosure, there is a light emitting diode transfer method including: transferring a plurality of light emitting diodes from a wafer to a first transfer substrate, wherein the plurality of light emitting diodes are arranged in a grid on the first transfer substrate; transferring, from the first transfer substrate to a second transfer substrate, the plurality of light emitting diodes at first predetermined intervals in a first direction; and transferring, from the second transfer substrate to a target transfer substrate, the plurality of light emitting diodes at second predetermined intervals in a second direction perpendicular to the first direction.

The grid may include a plurality of rows and a plurality of columns, an arrangement of the plurality of light emitting diodes on the first transfer substrate may include a first chip pitch, between the plurality of rows, and a second chip pitch between the plurality of columns, the plurality of light emitting diodes arranged on the second transfer substrate may be arranged with a third chip pitch between the plurality of rows, and the third chip pitch may be greater than the first chip pitch.

Transferring, from the second transfer substrate to a target transfer substrate, the plurality of light emitting diodes may include arranging the plurality of light emitting diodes in the target substrate in rows having a fourth chip pitch therebetween, wherein the fourth chip pitch may be greater than the second chip pitch.

Transferring, from the first transfer substrate to a second transfer substrate, the plurality of light emitting diodes may include arranging the plurality of light emitting diodes in the second transfer substrate in rows with the second chip pitch therebetween.

### [Brief Description of Drawings]

The above and other aspects, features, and advantages of certain embodiments of the disclosure will be more apparent from the following description taken in conjunction with the accompanying drawings, in which:
FIG. 1 is a view illustrating a transfer substrate according to one or more embodiments;
FIG. 2 is a flowchart illustrating a method for transferring a light emitting diode according to one or more embodiments;
FIG. 3, FIG. 4, and FIG. 5 are schematic diagrams illustrating an arrangement of a plurality of light emitting diodes on a first transfer substrate, a second transfer substrate, and a target substrate, according to one or more embodiments;
FIG. 6 is a schematic diagram illustrating a process of transferring a plurality of light emitting diodes to a target substrate through a first transfer substrate and a second transfer substrate sequentially through a transfer method according to one or more embodiments;
FIG. 7 is a diagram illustrating an example in which a plurality of light emitting diodes are provided on a first transfer substrate according to one or more embodiments;
FIG. 8 shows an example in which a plurality of light emitting diodes arranged on a first transfer substrate according to one or more embodiments are separated together with thin film layers provided on a first transfer substrate;
FIG. 9 is a diagram illustrating an example of aligning a first transfer substrate to a second transfer substrate according to one or more embodiments;
FIG. 10 is a diagram illustrating an example of laser-transferring a plurality of light emitting diodes from a first transfer substrate to a second transfer substrate according to one or more embodiments;
FIG. 11 is a diagram illustrating an example in which a plurality of light emitting diodes are arranged on a second transfer substrate according to one or more embodiments;
FIG. 12 is a diagram illustrating an example of aligning a second transfer substrate to a target substrate according to one or more embodiments;
FIG. 13 is a diagram illustrating an example of laser-transferring a plurality of light emitting diodes to a target substrate from a second transfer substrate according to one or more embodiments;
FIG. 14 is a diagram illustrating an example in which a plurality of light emitting diodes are transferred to a target substrate according to one or more embodiments;
FIG. 15 is a diagram illustrating an example of thermally compressing a plurality of light emitting diodes transferred to a target substrate by a pressing member according to one or more embodiments; and
FIG. 16. FIG. 17, FIG. 18, FIG. 19, FIG. 20, FIG. 21, FIG. 22, FIG. 23, FIG. 24, FIG. 25, FIG. 26, FIG. 27, FIG. 28, FIG. 29, FIG. 30, FIG. 31, FIG. 32, FIG. 33, and FIG. 34 are diagrams illustrating a method for manufacturing a display panel according to one or more embodiments for transferring light emitting diodes of different colors to a target substrate through a column direction stretch array after a row direction stretch array.
FIG. 35 is a block diagram illustrating a display device according to one or more embodiments.

### [MODE FOR INVENTION]

Hereinafter, various embodiments will be described in detail with reference to the accompanying drawings. The one or more embodiments described herein may be variously modified. Specific embodiments are depicted in the drawings and may be described in detail in the description of the disclosure. However, it is to be understood that the particular embodiments disclosed in the appended drawings are for ease of understanding of various embodiments. Therefore, it is intended that the invention not be limited to the particular embodiments disclosed in the accompanying drawings, but on the contrary, the intention is to cover all equivalents or alternatives falling within the spirit and scope of the disclosure.

Terms such as "first," "second," and the like may be used to describe various components, but the components should not be limited by the terms. The terms are used to distinguish a component from another. It is to be understood that the terms such as "comprise" or "consist of" are used herein to designate a presence of a characteristic, number, step, operation, element, component, or a combination thereof, and do not to preclude a presence or a possibility of adding one or more of other characteristics, numbers, steps, operations, elements, components or a combination thereof. It will be understood that when an element is referred to as being "coupled" or "connected" to another element, there may be other elements in the middle, although it may be directly coupled or connected to the other element. In contrast, when an element is referred to as being "directly coupled to" or "directly connected to" another element, there are no elements present therebetween. In the disclosure, the expression "same" may include not only a complete matching but also a different degree of processing error range. A detailed description of known functions or configurations incorporated herein will be shortened or omitted when it may make the subject matter of the disclosure rather unclear.

Hereinbelow, an embodiment of the disclosure will be described in detail with reference to the accompanying drawings so as to be easily carried out by a person skilled in the art to which the disclosure belongs. However, one embodiment of the disclosure may be implemented in various different forms, and is not limited to one embodiment of the disclosure described herein.

Hereinafter, a transfer substrate according to one or more embodiments and a method for transferring a light emitting diode using the same according to one or more embodiments will be described with reference to the drawings.

In the disclosure, "transfer" may refer to an operation of separating a plurality of light emitting diodes formed on a wafer from a wafer to align the light emitting diodes on a transfer substrate, and moving a plurality of light emitting diodes on the transfer substrate onto a target substrate (for example, a display substrate applied to a display panel). The wafer may have an epitaxial layer having a single crystal structure formed by growing silicon (Si), gallium arsenide (GaAs), or the like. The transfer substrate may be referred to as an interposer, a relay substrate, a carrier substrate, or a temporary substrate.

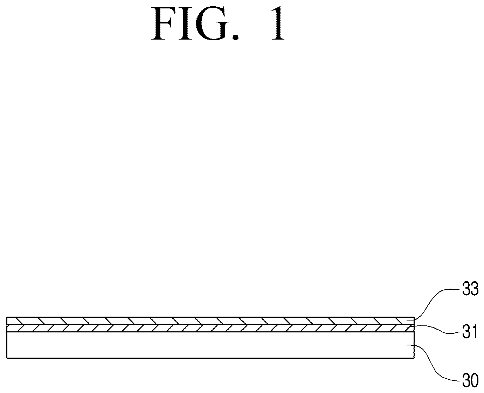

FIG. 1 is a view illustrating a transfer substrate according to one or more embodiments.

Referring to FIG. 1, two thin film layers may be provided on one surface of a transfer substrate 30 according to one or more embodiments. The two thin film layers may include a laser ablation layer 31 formed on the transfer substrate 30 and an adhesive layer 33 stacked on the laser ablation layer 31.

The transfer substrate 30 may be a light-transmitting substrate through which a laser beam may pass. For example, the transfer substrate 30 may be a glass substrate. Alternatively, in one or more other exemplary embodiments, the transfer substrate 30 may be a heat-resistant substrate to heat the laser ablation layer 31 with a laser beam to improve the transfer substrate 30 from changing when separating the light emitting diodes arranged on the transfer substrate 30 from the transfer substrate 30.

The laser ablation layer 31 may be made of a material that is instantly (e.g., several nano seconds) melted when absorbing a laser beam (e.g., a high-power pulse laser beam). Thus, the laser ablation layer 31 may be removed from the transfer substrate 30 by a laser beam.

The adhesive layer 33 may be configured to temporarily attach a plurality of light emitting diodes to the transfer substrate 30. The adhesive layer 33 may be a resin-based adhesive material, a rubber-based adhesive material, or a mixture-based adhesive material.

The resin-based adhesive material may be a thermosetting material (for example, a urea-based, a melanin-based, a phenol-based, an unsaturated polyester-based, an epoxy-based, resorcinol-based, or furan-based) or a thermoplastic material (for example, vinyl acetate-based, polyvinyl alcohol-based, vinyl chloride, polyvinylacetyl-based, acrylic, saturated polyester-based, polyamide-based, or polyethylene-based). The rubber-based adhesive material may be, for example, butadiene-based, nitrile-based, butyl-based, silicon-based, polychloroprene, or ethyl-based. The mixture-based adhesive material may be, for example, a phenolic vinyl-based, a phenolic chloroprene-based, a phenolic-nitrile-based, an epoxy polyamide-based, or a parylene-rubber epoxy-based.

A plurality of light emitting diodes may be arranged on the adhesive layer 33 after the laser ablation layer 31 and the adhesive layer 33 are sequentially stacked on the transfer substrate 30. The plurality of light emitting diodes arranged on the adhesive layer 33 may maintain a state of being attached to the adhesive layer 33 before the adhesive layer 33 is pre-cured and moved to the target substrate (or another transfer substrate).

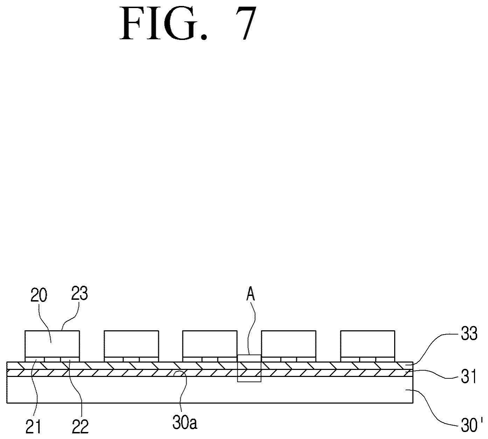

After a plurality of light emitting diodes are arranged in the adhesive layer 33, a part of the laser ablation layer 31 and the adhesive layer 33 may be removed from the transfer substrate 30 through an isolation method. The isolation method may be a method of removing a portion (e.g., portion A in FIG. 7) of the laser ablation layer 31 and the adhesive layer 33 that do not react to the plurality of light emitting diodes from the transfer substrate 30 by plasma etching after inserting the transfer substrate 30 into the plasma reaction chamber..

A portion of the laser ablation layer 31 and the adhesive layer 33 corresponding to each light emitting diode may remain on the transfer substrate 30 by an isolation method. Accordingly, the laser ablation layer 31 and the adhesive layer 33 stacked on the laser ablation layer 31 may be separated into multiple corresponding light emitting diodes on the transfer substrate 30.

When the laser beam is irradiated to the laser ablation layer 31, the laser ablation layer 31 may be vaporized and removed from the transfer substrate 30. The light emitting diode and the adhesive layer 33 corresponding to the light emitting diode may be transferred to the target substrate (or another transfer substrate) due to vapor pressure generated while the laser ablation layer 31 is vaporized.

In this example, the adhesive layer 33 that is transferred to a target substrate (or another transfer substrate) together with the light emitting diode is separated from adhesive layers corresponding to peripheral light emitting diodes. Therefore, the transfer operation of the light emitting diode transferred from the transfer substrate 30 to the target substrate (or another transfer substrate) may not be affected. The light emitting diode may be smoothly transferred from a transfer substrate to a target substrate (or another transfer substrate)

The transfer method according to one or more embodiments may be laser-transferring a plurality of light emitting diodes arranged on the transfer substrate 30 to a target substrate (or another transfer substrate) by using the transfer substrate 30 in which the laser ablation layer 31 and the adhesive layer 33 are stacked. In this example, the transfer substrate 30 may maintain a non-contact state with a target substrate (or another transfer substrate) disposed to face the transfer substrate 30. Here, the non-contact state may be a state in which a plurality of light emitting diodes arranged on the transfer substrate 30 are disposed at a predetermined interval from a target substrate (or another transfer substrate).

As the transfer substrate 30 and the target substrate (or another transfer substrate) maintain a non-contact state, laser-transferring may be performed while moving the target substrate (or another transfer substrate) at a constant speed. Alternatively, the laser-transferring may be performed while simultaneously moving the transfer substrate 30 and the target substrate (or another transfer substrate) at the same speed or at different speeds. Therefore, a transfer method according to one or more examples may improve a work speed compared to a transfer method in which laser transfer is performed in a state in which the related-art transfer method, that is, in which laser transfer is performed while a transfer substrate and a target substrate (or another transfer substrate) maintain a contact state.

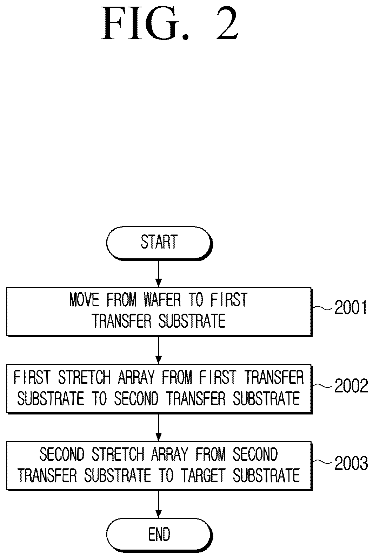

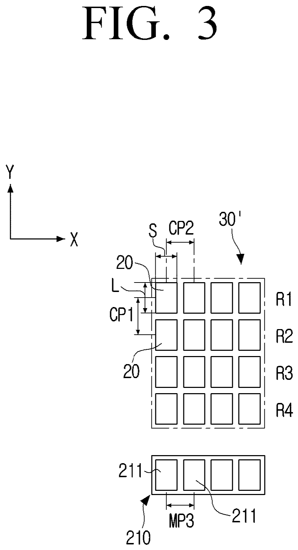

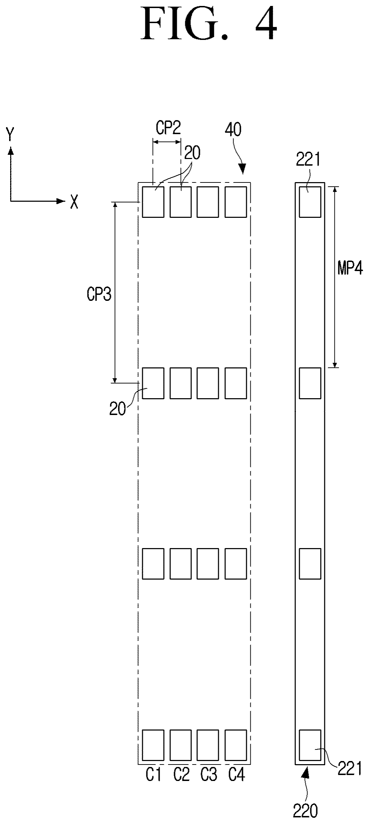

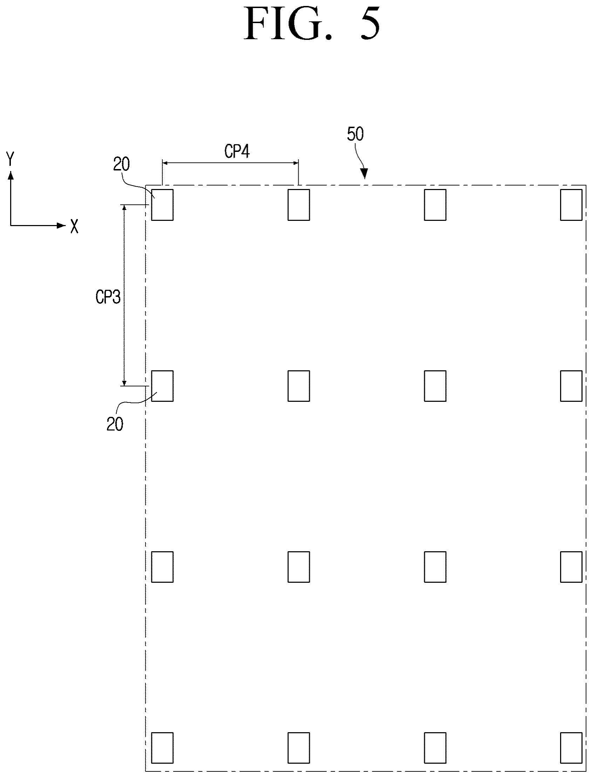

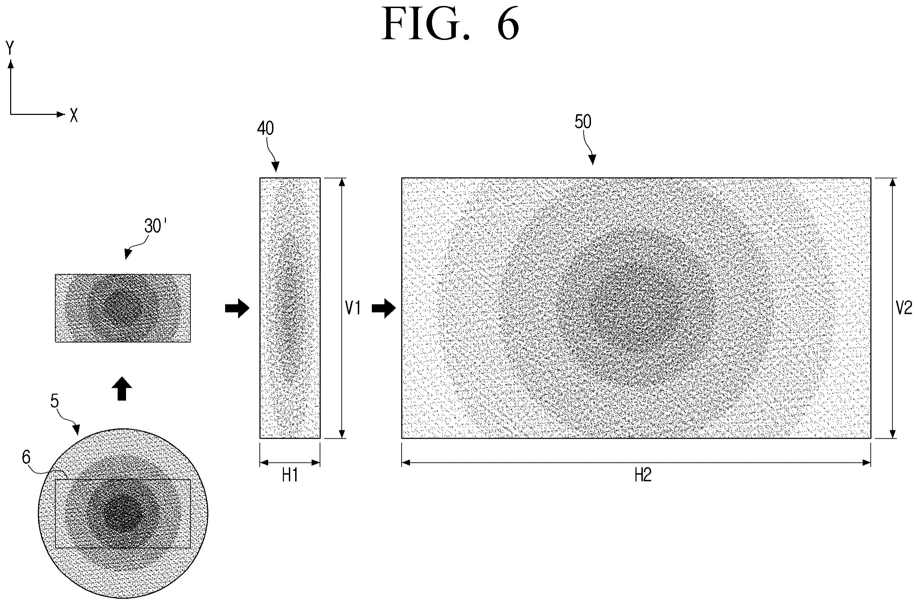

FIG. 2 is a flowchart illustrating a method for transferring a light emitting diode according to one or more embodiments. FIG. 3. FIG. 4, and FIG. 5 are schematic diagrams illustrating an arrangement of a plurality of light emitting diodes on a first transfer substrate, a second transfer substrate, and a target substrate, according to one or more embodiments. FIG. 6 is a schematic diagram illustrating a process of transferring a plurality of light emitting diodes to a target substrate through a first transfer substrate and a second transfer substrate sequentially through a transfer method according to one or more embodiments.

A light emitting diode transfer method according to one or more embodiments is as shown below, with reference to FIG. 2, FIG. 3, FIG. 4, FIG. 5, and FIG. 6.

A plurality of light emitting diodes may be formed from an epitaxial layer grown on the wafer 5 by an isolation method. In this example, the plurality of light emitting diodes 20 of the wafer 5 may be disposed at regular intervals in a first direction (for example, the Y-axis direction of FIG. 3) and may be arranged at regular intervals in a second direction (for example, the X-axis direction in FIG. 3) perpendicular to the first direction. An interval along a first direction (Y-axis direction) of the plurality of light emitting diodes 20 and an interval along the second direction (X-axis direction) may be minimum intervals available in a process. Accordingly, the number of light emitting diodes provided in one wafer may be maximally increased, and manufacturing costs of a plurality of light emitting diodes may be reduced.

A plurality of light emitting diodes 20 formed on the wafer 5 are moved to a first transfer substrate 30' (at element 2001 of FIG. 2). In this example, in order to separate the plurality of light emitting diodes 20 from the wafer 5, the wafer 5 and the first transfer substrate 30' are thermally compressed to attach a plurality of light emitting diodes 20 formed on the wafer 5 to the first transfer substrate 30'. The wafer 5 may be separated from the plurality of light emitting diodes 20 through a laser lift-off (LLO) method.

On the first transfer substrate 30', a laser ablation layer 31 formed on the first transfer substrate 30' and an adhesive layer 33 (e.g., see FIG. 7) formed on the laser ablation layer 31 (e.g., see FIG. 7) may be provided.

A plurality of light emitting diodes 20 may be fixed to the first transfer substrate 30' by the adhesive layer 33. The laser ablation layer 31 formed on the first transfer substrate 30' may be vaporized by a laser beam emitted from a laser oscillator of the laser transfer device when transferring the plurality of light emitting diodes 20 from the first transfer substrate 30' to the second transfer substrate 40. Accordingly, the plurality of light emitting diodes 20 may be separated from the first transfer substrate 30' and transferred to the second transfer substrate 40 due to vapor pressure generated while the laser ablation layer 31 is vaporized.

Referring to FIG. 3, a plurality of light emitting diodes 20 transferred to the first transfer substrate 30' may be arranged on the first transfer substrate 30' while maintaining a characteristic distribution (for example, mura) illustrated in the wafer 5. In this example, the first transfer substrate 30' may be formed in the same or similar size and shape (e.g., square) as a region 6 (e.g., see FIG. 6) transferred from the wafer 5.

In the wafer 5 and the first transfer substrate 30', a reference, for example, a flat zone or a notch, for recognizing horizontality and verticality through a sensor (e.g., a vision camera) may be formed.

A plurality of light emitting diodes 20 arranged in a first direction (Y-axis direction) and a second direction (X-axis direction) on the first transfer substrate 30' may be arranged in a grid form. A plurality of light emitting diodes 20 may be arranged in a first direction (Y-axis direction) at a first chip pitch CP1 and in a second direction (X-axis direction) at a second chip pitch CP2. The first chip pitch CP1 and the second chip pitch CP2 on the first transfer substrate 30' may be intervals maintained as close as possible to the extent that they do not affect adjacent light emitting diodes.

The horizontal length S of each light emitting diode of the first transfer substrate 30' may be smaller than the vertical length L. However, the embodiments are not limited thereto and the horizontal length S and the vertical length L of each light emitting diode 20 may be the same or the horizontal length S may be greater than the vertical length L.

When the transfer of the plurality of light emitting diodes 20 to the first transfer substrate 30' is completed, as illustrated in FIG. 4, the plurality of light emitting diodes 20 arranged on the first transfer substrate 30' are transferred to have a first stretch array on the second transfer substrate 40 (at element 2002 of FIG. 2).

The first stretch array may denote that the plurality of light emitting diodes 20 are disposed on the second transfer substrate 40 in a way that spacing between the light emitting diodes 20 of the first transfer substrate 30' is spaced in the first direction (Y-axis direction) so that a constant third chip pitch CP3 is maintained.

The first stretch array may be made through laser transfer by a laser transfer device. The first transfer substrate 30' may be provided to a first stage of the laser transfer device, and a second transfer substrate 40 may be provided on a second stage disposed below the first stage. The first stage and the second stage may move along an x-axis, a y-axis, and a z-axis

The first transfer substrate 30' and the second transfer substrate 40 may be aligned by the first stage and the second stage. When the laser beam is irradiated toward the first transfer substrate 30', the laser beam is irradiated to the first transfer substrate 30' through a plurality of slits 211 of the first mask 210 illustrated in FIG. 3.

Each slit 211 of the first mask 210 may be arranged at the same first opening pitch (MP3) as the second chip pitch CP2 along the second direction (X-axis direction). The number of the plurality of slits 211 of the first mask 210 may correspond to the number of light emitting diodes 20 arranged in one row of the first transfer substrate 30'. Accordingly, a plurality of light emitting diodes 20 of the first transfer substrate 30 may be sequentially moved to the second transfer substrate 40 by one row.

A plurality of light emitting diodes 20 of a first row R1 of the first transfer substrate 30' may be separated from the first transfer substrate 30' and moved to the second transfer substrate 40 by a laser beam irradiated to the first transfer substrate 30'. The first stage and the second stage respectively move to a preset laser irradiation location in order to move the plurality of light emitting diodes 20 of the second row R2 of the first transfer substrate 30' to the second transfer substrate 40.

A plurality of light emitting diodes 20 of a second row R2 of the first transfer substrate 30' may be separated from the first transfer substrate 30' by a laser beam irradiated to the first transfer substrate 30' and may be moved to the second transfer substrate 40. In this example, the plurality of light emitting diodes 20 of the second row R2 moved to the second transfer substrate 40 may be arranged to have a third chip pitch CP3 in a first direction (Y-axis direction) with a plurality of light emitting diodes 20 of the first row R1 of the second transfer substrate 40. The third chip pitch CP3 may be set to be greater than the second chip pitch CP2.

By repeating this process, the plurality of light emitting diodes 20 in the third row R3 and the fourth row R4 of the first transfer substrate 30' may be moved to the second transfer substrate 40 to have the third chip pitch CP3 sequentially.

Each row of the plurality of light emitting diodes 20 moved to the second transfer substrate 40 may be arranged to maintain the third chip pitch CP3 along a first direction (Y-axis direction), and a plurality of light emitting diodes 20 in each row may be arranged to maintain the first chip pitch CP1 in a second direction (X-axis direction).

As such, the plurality of light emitting diodes 20 of the second transfer substrate 40 have the first stretch array spaced at regular intervals in the first direction (Y-axis direction) than the arrangement on the first transfer substrate 30'.

In consideration of the first stretch array in which the chip pitch increases in the first direction (Y-axis direction), the vertical length V1 of the second transfer substrate 40 may be formed to be longer than the horizontal length H1 as illustrated in FIG. 6.

When the first stretch array is completed, the plurality of light emitting diodes 20 arranged on the second transfer substrate 40 are moved to the target substrate 50 to have a second stretch array in the target substrate 50 as illustrated in FIG. 5 (at element 2003 of FIG.2).

The second stretch array is to dispose the plurality of light emitting diodes 20 of the second transfer substrate 40 in the target substrate 50 in the second direction (X-axis direction) so as to have a fourth chip pitch CP4 greater than the second chip pitch CP2.

The second stretch array may be performed through a laser transfer method by a laser transfer device. For this, the second transfer substrate 40 may be provided to a first stage of a laser transfer device, and a target substrate 50 may be provided to a second stage to be disposed below the second transfer substrate 40.

The first stage and the second stage move to an irradiation location of a preset laser beam. When a laser beam is irradiated from the laser oscillator toward the second transfer substrate 40, the laser beam is irradiated to the second transfer substrate 40 through a plurality of slits 221 of the second mask 220 illustrated in FIG. 4.

Each slit 221 of the second mask 220 may be disposed at the same second opening pitch MP4 as the fourth chip pitch CP5. The plurality of slits 221 of the second mask 220 may be provided to be the same as the number of the plurality of light emitting diodes 20 arranged in one column of the second transfer substrate 40.

A plurality of light emitting diodes 20 of the second transfer substrate 40 may be moved to the target substrate 50 at a fourth chip pitch CP4 corresponding to a plurality of slits 221 of the second mask 220 with respect to one column. In this example, a plurality of light emitting diodes 20 may be spaced in a second direction (X-axis direction) and moved to the target substrate 50.

A plurality of light emitting diodes 20 of a first column C1 of the second transfer substrate 40 may be moved to the target substrate 50 by a laser beam irradiated to the second transfer substrate 40. The first stage and the second stage respectively move to a laser irradiation location to move a plurality of light emitting diodes 20 of a second row C2 of the second transfer substrate 40 to the target substrate 50.

A light emitting diode 20 of a second column C2 of the second transfer substrate 40 is moved to the target substrate 50 by a laser beam irradiated to the second transfer substrate 40. In this example, the light emitting diodes of the second column moved to the target substrate 50 have a fourth chip pitch CP4 in a second direction (X-axis direction) with a plurality of light emitting diodes 20 of the first column C1 of the target substrate 50 that were moved immediately before. The fourth chip pitch CP4 may be greater than the second chip pitch CP2.

The plurality of light emitting diodes 20 in the third column C3 and the fourth column C4 of the second transfer substrate 40 may be moved to the target substrate 50 to have the fourth chip pitch CP4 sequentially.

Referring to FIG. 5, a plurality of light emitting diodes 20 moved to the target substrate 50 may be arranged to have the third chip pitch CP3 in a first direction (Y-axis direction) and a fourth chip pitch CP4 in a second direction (X-axis direction). Accordingly, the plurality of light emitting diodes 20 arranged on the target substrate 50 may be arranged in a stretched state in the first direction (Y-axis direction) and the second direction (X-axis direction) with respect to the arrangement of the plurality of light emitting diodes arranged on the first transfer substrate 30.

Referring to FIG. 6, a light emitting diode transfer method according to one or more embodiments moves a plurality of light emitting diodes 20 arranged in a predetermined region 6 of the wafer 5 to the first transfer substrate 30'. The plurality of light emitting diodes 20 of the first transfer substrate 30 may be arranged at the first chip pitch CP1 and the second chip pitch CP2.

The first chip pitch CP1 is substantially the same as the chip pitch in the first direction (Y-axis direction) of the plurality of light emitting diodes 20 of the wafer 5, and the second chip pitch CP2 may be substantially the same as the chip pitch in the second-direction (X-axis direction) of the plurality of light emitting diodes 20 of the wafer 5.

The characteristic distribution of the plurality of light emitting diodes 20 moved to the first transfer substrate 30' may be substantially the same as the characteristic distribution of the plurality of light emitting diodes 20 arranged in a specific region 6 of the wafer 5.

A plurality of light emitting diodes 20 arranged in the first transfer substrate 30' may be moved to the second transfer substrate 40 in a first stretch array. In this example, the characteristic distribution of the plurality of light emitting diodes 20 moved to the second transfer substrate 40 may be different from the characteristic distribution of the plurality of light emitting diodes 20 arranged on the first transfer substrate 30'. For example, the characteristic distribution of the plurality of light emitting diodes 20 of the second transfer substrate 40 may appear to be stretched in the first direction (Y-axis direction) with respect to the characteristic distribution of the plurality of light emitting diodes 20 of the first transfer substrate 30'.

A plurality of light emitting diodes 20 of the second transfer substrate 40 may be moved to the target substrate 50 in a second stretch array. In this example, the characteristic distribution of the plurality of light emitting diodes 20 moved to the target substrate 50 may be different from the characteristic distribution of the plurality of light emitting diodes 20 arranged on the second transfer substrate 40. For example, the characteristic distribution of the plurality of light emitting diodes 20 of the target substrate 50 may appear to be stretched in the second direction (X-axis direction) with respect to the characteristic distribution of the plurality of light emitting diodes 20 of the second transfer substrate 40.

In a related-art light emitting diode transfer method, when a plurality of light emitting diodes 20 formed on one wafer 5 are grouped according to characteristics of each light emitting diode through a binning process and transferred to the target substrate 50, a periodic pattern may appear on the target substrate and the mura visibility ratio may be improved. However, in the light emitting diode transfer method according to one or more embodiments of the disclosure, a characteristic distribution of a plurality of light emitting diodes 20 present on the target substrate 50 appears substantially the same as a characteristic distribution of a plurality of light emitting diodes 20 present on the wafer 5, so mura visibility may be improved.

Hereinafter, a method for transferring a light emitting diode according to one or more embodiments will be described in detail with reference to FIG. 7, FIG. 8, FIG. 9, FIG. 10, FIG. 11, FIG. 12, FIG. 13, FIG. 14, FIG. 15, and FIG. 16.

FIG. 7 is a diagram illustrating an example in which a plurality of light emitting diodes are provided on a first transfer substrate according to one or more embodiments.

Referring to FIG. 7, the laser ablation layer 31, which may be removed by a laser beam, is formed on one surface 30a of the first transfer substrate 30' at a predetermined thickness (for example, several micrometers). The laser ablation layer 31 is pre-cured or cured so that the laser ablation layer 31 may maintained own shape without flowing down on the first transfer substrate 30'.

The adhesive layer 33 is laminated on the laser ablation layer 31 at a predetermined thickness (for example, several micrometers). The adhesive layer 33 may be pre-cured so that the laser ablation layer 31 maintains the shape.

A wafer is aligned on the upper side of a first transfer substrate 30' provided with the laser ablation layer 31 and the adhesive layer 33. A plurality of light emitting diodes 20 may be provided at a constant pitch on the wafer. Each light emitting diode 20 may be formed in the form of a flip chip in which a first electrode (for example, an anode electrode 21) and a second electrode (for example, a cathode electrode 22) are provided on the opposite side of the light emitting surface 23.

A plurality of light emitting diodes 20 are transferred to the first transfer substrate 30' from the wafer 5 (see FIG. 6). The plurality of light emitting diodes 20 transferred to the first transfer substrate 30' may be arranged at substantially the same chip pitch as the chip pitch arranged on the wafer 5. Adjacent light emitting diodes 20 of the first transfer substrate 30' may be arranged at regular intervals in a first direction (Y-axis direction in FIG. 3) and a second direction (X-axis direction in FIG. 3). Accordingly, a portion A of the adhesive layer 33 not occupied by the plurality of light emitting diodes 20 may be exposed.

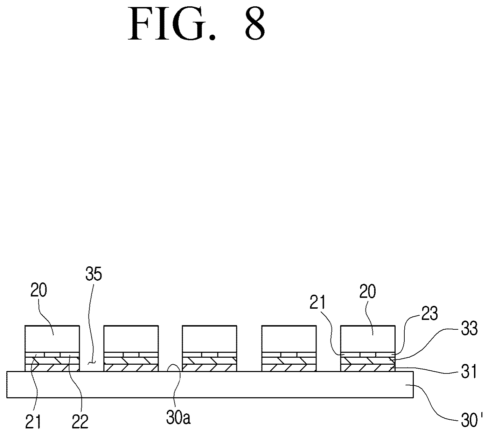

FIG. 8 shows an example in which a plurality of light emitting diodes arranged on a first transfer substrate according to one or more embodiments are separated together with thin film layers provided on a first transfer substrate.

Referring to FIG. 8, a portion A (FIG. 7) of the laser ablation layer 31 and the adhesive layer 33 not corresponding to each of the light emitting diodes 20 may be removed from the first transfer substrate 30' by an isolation method. A portion of the laser ablation layer 31 and the adhesive layer 33 corresponding to each light emitting diode 20 may remain on the first transfer substrate 30'.

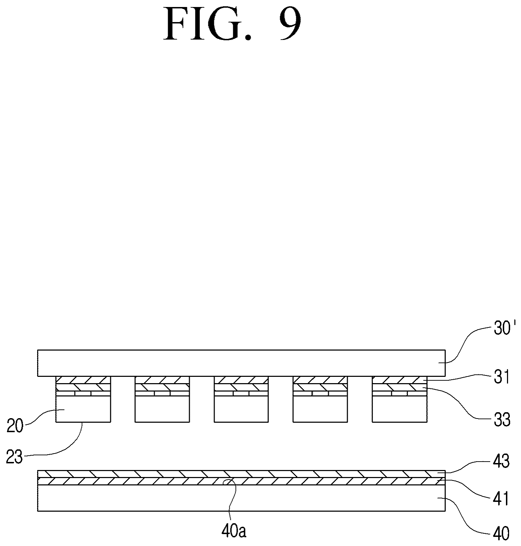

FIG. 9 is a diagram illustrating an example of aligning a first transfer substrate to a second transfer substrate according to one or more embodiments.

Referring to FIG. 9, the first transfer substrate 30' and the second transfer substrate 40 are aligned. The first transfer substrate 30' and the second transfer substrate 40 may be disposed in a non-contact state. In this example, in a plurality of light emitting diodes 20 arranged on the first transfer substrate 30', the light emitting surface may face the second transfer substrate 40.

On one surface 40a, as in FIG. 9, of the second transfer substrate 40 facing a plurality of light emitting diodes 20 of the first transfer substrate 30, the laser ablation layer 41 and the adhesive layer 43 stacked on the laser ablation layer 41 may be provided in a similar manner with the first transfer substrate 30'.

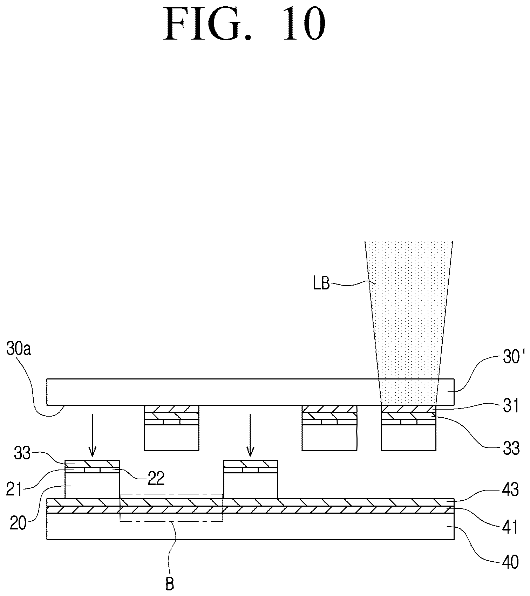

FIG. 10 is a diagram illustrating an example of laser-transferring a plurality of light emitting diodes from a first transfer substrate to a second transfer substrate according to one or more embodiments.

Referring to FIG. 10, a laser beam (LB) is irradiated onto the first transfer substrate 30' to transfer a plurality of light emitting diodes 20 from the first transfer substrate 30' to the second transfer substrate 40. In this example, the plurality of light emitting diodes 20 may be stretched in a first direction (Y-axis direction in FIG. 4).

A plurality of light emitting diodes 20 arranged on the second transfer substrate 40 may be separated from the first transfer substrate 30' together with the adhesive layer 33. In this example, the adhesive layer 33 may cover the first electrode 21 and the second electrode 22 of the light emitting diode 20.

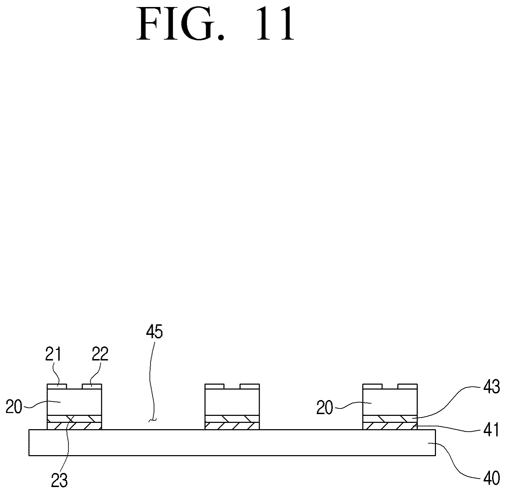

FIG. 11 is a diagram illustrating an example in which a plurality of light emitting diodes are arranged on a second transfer substrate according to one or more embodiments.

Referring to FIG. 11, after all of the plurality of light emitting diodes 20 are moved from the first transfer substrate 30' to the second transfer substrate 40, the adhesive layer 33 attached to each of the light emitting diodes 20 may be removed by an etching process.

In the second transfer substrate 40, a portion B in FIG. 10 of the laser ablation layer 41 and the adhesive layer 43, which do not correspond to the plurality of light emitting diodes 20, may be removed from the second transfer substrate 40 by an isolation method. A portion of the laser ablation layer 41 and the adhesive layer 43 corresponding to each light emitting diode 20 may remain on the second transfer substrate 40.

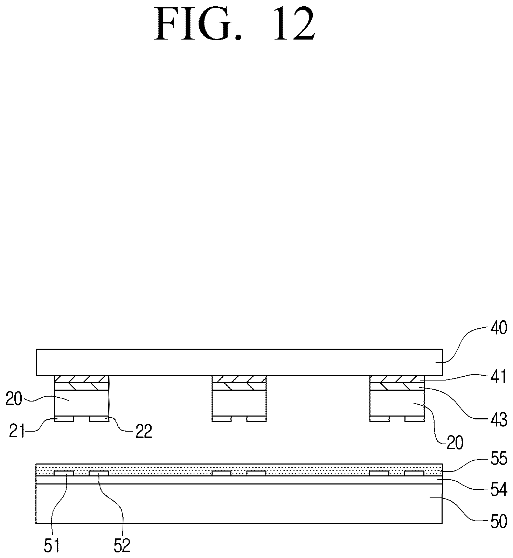

FIG. 12 is a diagram illustrating an example of aligning a second transfer substrate to a target substrate according to one or more embodiments.

Referring to FIG. 12, the second transfer substrate 40 and the target substrate 50 are aligned so that a first electrode 21 and a second electrode 22 of each light emitting diode 20 of the second transfer substrate 40 may be connected to a first substrate pad 51 and a second substrate pad 52 of the corresponding target substrate 50. In a plurality of light emitting diodes 20 arranged on the second transfer substrate 40, the first electrode 21 and the second electrode 22 may face the target substrate 50. The second transfer substrate 40 and the target substrate 50 may be arranged in a non-contact state.

The target substrate 50 has a TFT layer 54 formed on the front surface to which the plurality of light emitting diodes 20 are transferred, and a power supply circuit, a data driving driver, a gate driving driver, and a timing controller for controlling each driving driver may be arranged on the rear surface of the target substrate 50.

The TFT layer 54 may include a plurality of TFTs for driving a plurality of light emitting diodes 20. The TFT color layer 54 may be integrally formed on the front surface of the target substrate 50, but is not limited thereto, and may be manufactured in a separate film form and attached to the front surface of the target substrate 50. The first substrate pad 51 and the second substrate pad 52 disposed on the TFT layer 54 may be electrically connected to the TFT layer 54.

The plurality of TFTs included in the TFT layer 54 are not limited to a specific structure or type. For example, the TFT may be implemented as a low-temperature polycrystalline silicon TFT (LTPS TFT), an oxide TFT, poly silicon, a-silicon (Si TFT), an organic TFT, a graphene TFT, or the like. The TFT layer 54 may be applied to the target substrate 50 by forming the Si wafer with a P-type (or N-type) metal oxide semiconductor field effect transistor (MOSFET) in a complementary metal oxide semiconductor (CMOS) process.

A conductive adhesive layer 55 may be stacked on the TFT layer 54. The conductive adhesive layer 730 may include a flux including a plurality of fine metal particles. For example, the conductive adhesive layer 55 may be an anisotropic conductive film in which a non-conductive resin and fine conductive particles are regularly or irregularly arranged in the non-conductive resin. In this example, the non-conductive resin may have a black tone color to absorb external light. The external light may be light emitted from natural light or lighting disposed around the display panel.

The conductive adhesive layer 55 may electrically or physically connect the first electrode 21 and the second electrode 22 of each light emitting diode 20 to the first substrate pad 51 and the second substrate pad 52 of the corresponding target substrate 50.

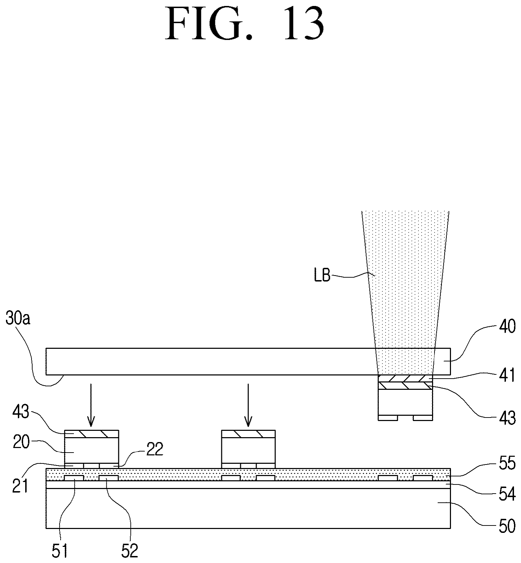

FIG. 13 is a diagram illustrating an example of laser-transferring a plurality of light emitting diodes to a target substrate from a second transfer substrate according to one or more embodiments.

Referring to FIG. 13, a plurality of light emitting diodes 20 may be transferred from the second transfer substrate 40 to the target substrate 50 by irradiating the second transfer substrate 40 with a laser beam LB. In this example, the plurality of light emitting diodes 20 may be arrayed in a stretched manner in a second direction (X-axis direction in FIG. 5).

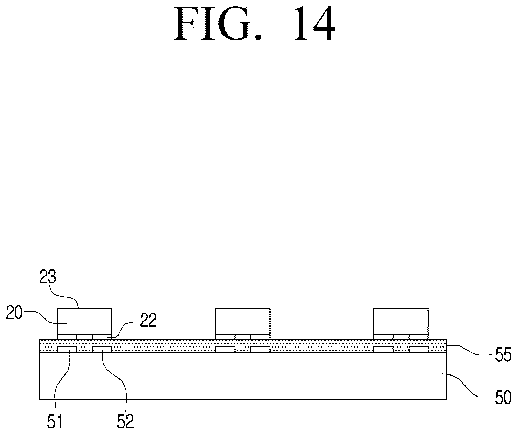

FIG. 14 is a diagram illustrating an example in which a plurality of light emitting diodes are transferred to a target substrate according to one or more embodiments.

Referring to FIG. 14, after transferring all of the plurality of light emitting diodes from the second transfer substrate 40 to the target substrate 50, the adhesive layer 43 (see FIG. 13) remaining on the light emitting surface 23 of each light emitting diode 20 may be removed through an etching process.

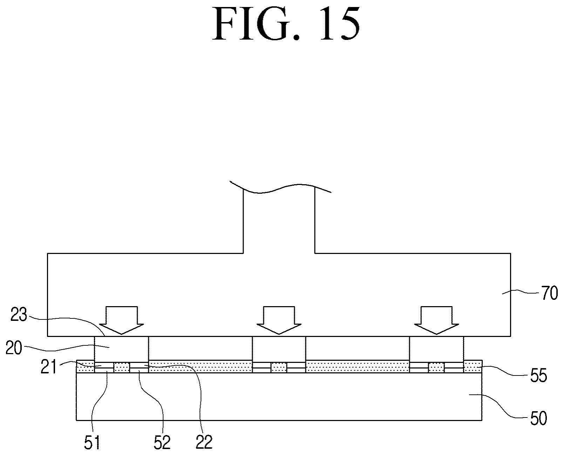

FIG. 15 is a diagram illustrating an example of thermally compressing a plurality of light emitting diodes transferred to a target substrate by a pressing member according to one or more embodiments.

Referring to FIG. 15, a plurality of light emitting diodes 20 arranged on the target substrate 50 may be pressurized toward the target substrate 50 by a pressing member 70 having a heater embedded therein. In this example, a separate heater may also be disposed in the stage on which the target substrate 50 is seated.

The conductive adhesive layer 55 may be melted by heat emitted from the stage and the pressing member 70. When the plurality of light emitting diodes 20 are pressed toward the target substrate 50 by the pressing member 70, the first electrode 21 and the second electrode 22 of the plurality of light emitting diodes 20 may be electrically connected to the first substrate pad 51 and the second substrate pad 52 of the corresponding target substrate 50. Thereafter, when the conductive adhesive layer 55 is cured, the first electrode 21 and the second electrode 22 of the plurality of light emitting diodes 20 may be physically fixed to the target substrate 50.

The method for transferring a light emitting diode according to one or more embodiments may transfer a plurality of light emitting diodes 20 of a single color from the wafer 5 to the target substrate 50 by a stretch array in a first direction and a second direction. Accordingly, the characteristic distribution of the plurality of light emitting diodes 20 transferred to the target substrate 50 may be substantially the same as the characteristic distribution of the plurality of light emitting diodes 20 of the wafer.

Hereinafter, a method for manufacturing a display panel by transferring light emitting diodes of different colors from a plurality of wafers to a target substrate by using a transfer substrate according to one or more embodiments including a laser ablation layer and an adhesive layer stacked thereon will be described.

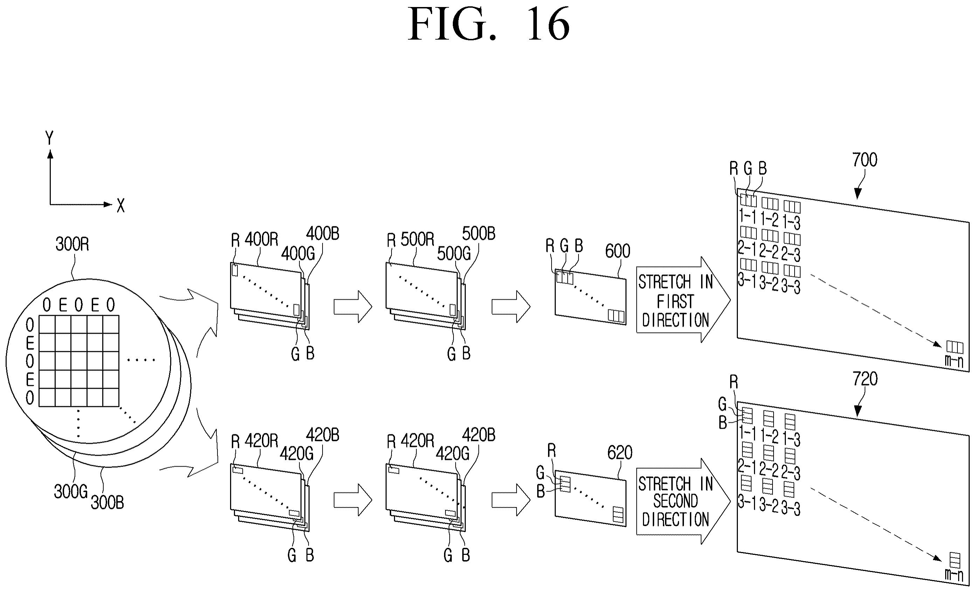

FIG. 16, FIG. 17, FIG. 18, FIG. 19, FIG. 20, FIG. 21, FIG. 22, FIG. 23, FIG. 24, FIG. 25, FIG. 26, FIG. 27, FIG. 28, FIG. 29, FIG. 30, FIG. 31, FIG. 32, FIG. 33, and FIG. 34 are diagrams illustrating a method for manufacturing a display panel according to one or more embodiments for transferring light emitting diodes of different colors to a target substrate through a column direction stretch array after a row direction stretch array.

Referring to FIG. 16, red, green, and blue wafers (hereinafter, "wafers") (red wafer 300R, green wafer 300G, blue wafer 300B) in which a plurality of LEDs are respectively formed in a grid array may be provided singly for each color. The red wafer is a wafer provided with a red light emitting diode, the green wafer is a wafer provided with a green light emitting diode, and the blue wafer is a wafer provided with a blue light emitting diode.

An alphabet 'O' displayed on the red wafer 300R means an ODD and an alphabet 'E' may represent an EVEN. For convenience of description, only some of the light emitting diodes of each color arranged in the wafers, the red wafer 300R, the green wafer 300G, the blue wafer 300B, will be illustrated and described.

A red wafer 300R may be formed by an isolation method such that an interval along a first direction between a plurality of red light emitting diodes 410 and an interval along a second direction may maintain a minimum processible interval.

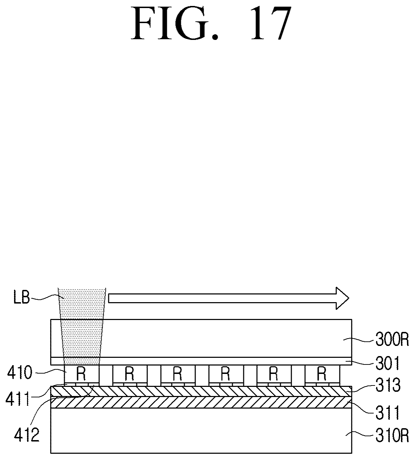

Referring to FIG. 17, a plurality of red light emitting diodes 410 may be moved to a first red transfer substrate 310R by laser transfer from the red wafer 300. In this example, the laser ablation layer 311 and the adhesive layer 313 stacked on the laser ablation layer 311 may be provided on the first red transfer substrate 310R. A plurality of red light emitting diodes 410 may be attached to the adhesive layer 313.

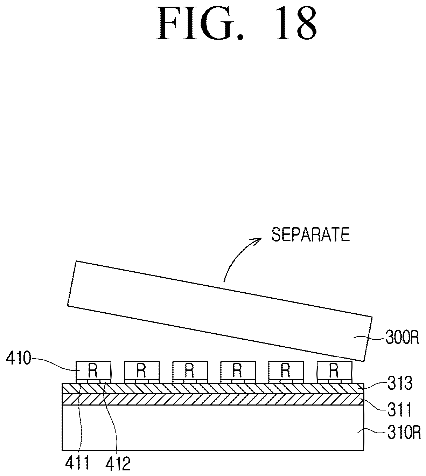

Referring to FIG. 18, when a plurality of red light emitting diodes 410 are transferred from the red wafer 300R to the first red transfer substrate 310R, the red wafer 300R is separated from a plurality of red light emitting diodes 410 by a LLO method.

By the above method, a plurality of green light emitting diodes may be transferred from the green wafer 300G to the first green transfer substrate, and a plurality of blue light emitting diodes may be transferred from the blue wafer 300B to the first blue transfer substrate.

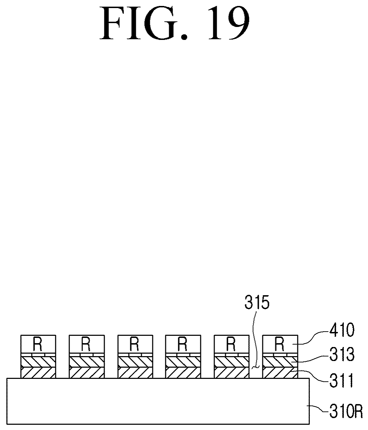

Referring to FIG. 19, a portion 315 of the laser ablation layer 311 and the adhesive layer 313 that do not correspond to the plurality of red light emitting diodes 410 in the first red transfer substrate 310R may be removed by plasma etching. Accordingly, the laser ablation layer 311 and the adhesive layer 313 may be divided into the number corresponding to each red light emitting diode 410 in the first red transfer substrate 310R.

By the above method, a portion of the laser ablation layer and the adhesive layer, which do not correspond to the plurality of green light emitting diodes, may be removed from the first green transfer substrate by plasma etching. A portion of the laser ablation layer and the adhesive layer that do not correspond to the plurality of blue light emitting diodes may be removed from the first blue transfer substrate by plasma etching.

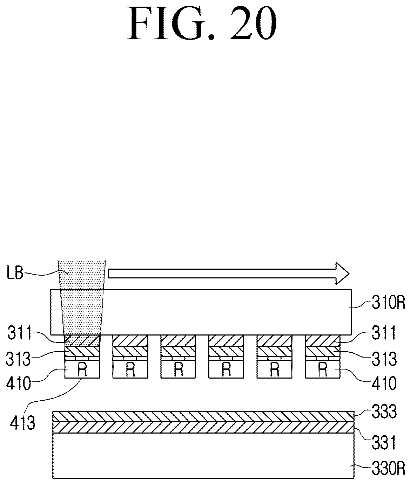

Referring to FIG. 20, the first red transfer substrate 310R and the second red transfer substrate 330R are aligned. In this example, in the plurality of red light emitting diodes 410, the light emitting surface 413 faces the adhesive layer 333 of the second red transfer substrate 330R.

When the laser beam LB is irradiated to the laser ablation layer 311 corresponding to each red light emitting diode 410, a plurality of red light emitting diodes 410 may be moved from the first red transfer substrate 310R to the second red transfer substrate 330R while the laser ablation layer 311 is removed. A plurality of red light emitting diodes 410 may be mounted on the adhesive layer 333 of the second red transfer substrate 330R.

In this example, as the adhesive layer 333 of the first red transfer substrate 310R is divided into a plurality of portions to correspond to each red light emitting diode 410, the laser ablation layer 311 is removed by the laser beam LB, and thus the red light emitting diode 410 may be immediately separated from the first red transfer substrate 310R. Accordingly, during laser transfer, a plurality of red light emitting diodes may be transferred from the first red transfer substrate 310R while moving at a constant speed without fixing the second red transfer substrate 330R and therefore, the time required for transferring may be shortened.

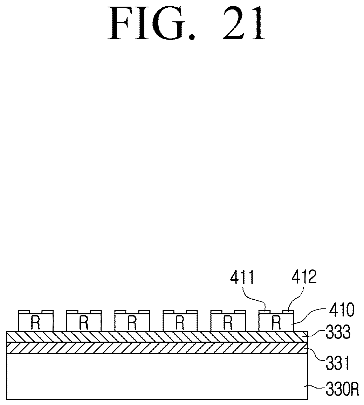

Referring to FIG. 21, a plurality of red light emitting diodes 410 may be transferred to the second red transfer substrate 330R together with the adhesive layer 313 covering the first electrode 411 and the second electrode 412. In this example, the adhesive layer 333 of each red light emitting diode 410 may be removed by an etching process.

A portion of the adhesive layer 333 and the laser ablation layer 331 that do not correspond to the plurality of green light emitting diodes moved to the second red transfer substrate 330R may be removed by plasma etching.

In the method described above, a plurality of green light emitting diodes of a first green transfer substrate may be moved to a second green transfer substrate. A plurality of blue light emitting diodes of the first blue transfer substrate may be moved to the second blue transfer substrate.

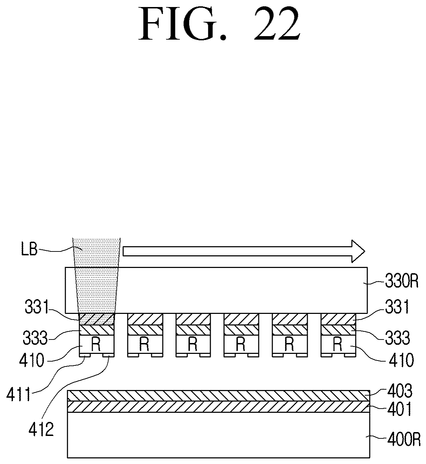

Referring to FIG. 22, the second red transfer substrate 330R and the third red transfer substrate 400R are aligned. In this example, in the plurality of red light emitting diodes 410, the first electrode 411 and the second electrode 412 face the adhesive layer 403 of the third red transfer substrate 400R.

When a laser beam LB is irradiated to the laser ablation layer 401 corresponding to each red light emitting diode 410, a plurality of red light emitting diodes 410 may be moved from the second red transfer substrate 330R to the third red transfer substrate 400R while the laser ablation layer 401 is removed. A plurality of red light emitting diodes 410 may be seated on the adhesive layer 403 of the third red transfer substrate 400R.

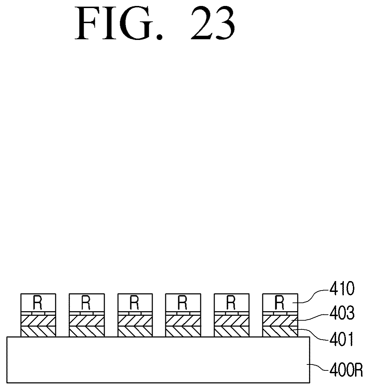

Referring to FIG. 23, a plurality of red light emitting diodes 410 may be moved to the second red transfer substrate 330R together with the adhesive layer 313 covering the light emitting surface 413. In this example, the adhesive layer 333 covering the light emitting surface 413 of each red light emitting diode 410 may be removed by an etching process.

A portion of the laser ablation layer 401 and the adhesive layer 403, which do not correspond to the plurality of green light emitting diodes moved to the third red transfer substrate 400R, may be removed by plasma etching.

In the method described above, a plurality of green light emitting diodes of a second green transfer substrate may be transferred to a third green transfer substrate 400G. A plurality of blue light emitting diodes of the second blue transfer substrate may be moved to the third blue transfer substrate 400B.

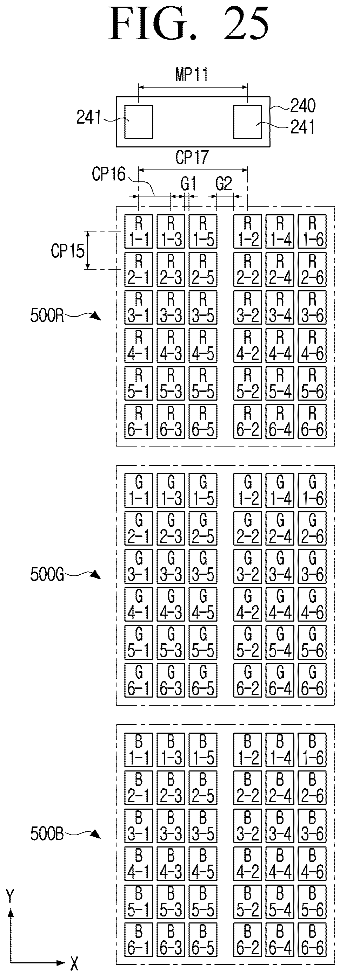

Referring to FIG. 25, a plurality of red light emitting diodes arranged in the third red transfer substrate 400R may have a fifth chip pitch CP15 in a first direction (Y-axis direction) and may have a sixth chip pitch CP16 in a second direction (X-axis direction). The fifth chip pitch CP15 and the sixth chip pitch CP16 may be substantially the same as the pitch in the first and second directions between the red light emitting diodes 410 arranged on the red wafer 300R. The adjacent red light emitting diodes of the third red transfer substrate 400R may maintain the first interval G1.

In the method as described above, a plurality of green light emitting diodes and a plurality of blue light emitting diodes may be arranged on the third green transfer substrate 400G and the third blue transfer substrate 400B, respectively. In this example, the plurality of green light emitting diodes arranged on the third green transfer substrate 400G and the plurality of blue light emitting diodes arranged on the third blue transfer substrate 400B each have the fifth chip pitch CP15 in the first direction (Y-axis direction) and have the sixth chip pitch CP16 in the second direction (X-axis direction).

In the disclosure, for convenience of description, only a portion (6 × 6) of a plurality of light emitting diodes of each color arranged in the third transfer substrates, the third red transfer substrate 400R, the third green transfer substrate 400G, and the third blue transfer substrate 400B, is illustrated and described. In addition, the size or length of the mask used in the laser transfer is also reduced in consideration of the number of light emitting diodes of each color.

The red, green, and blue light emitting diodes of the third red, green, and blue transfer substrates (the third red transfer substrate 400R, the third green transfer substrate 400G, and the third blue transfer substrate 400B) may be moved by means of a laser transfer method to the fourth red transfer substrate 500R, the fourth green transfer substrate 500G, and the fourth blue transfer substrate 500Bcorresponding to the third red transfer substrate 400R, the third green transfer substrate 400G, and the third blue transfer substrate 400B, respectively, as illustrated in FIG. 25.

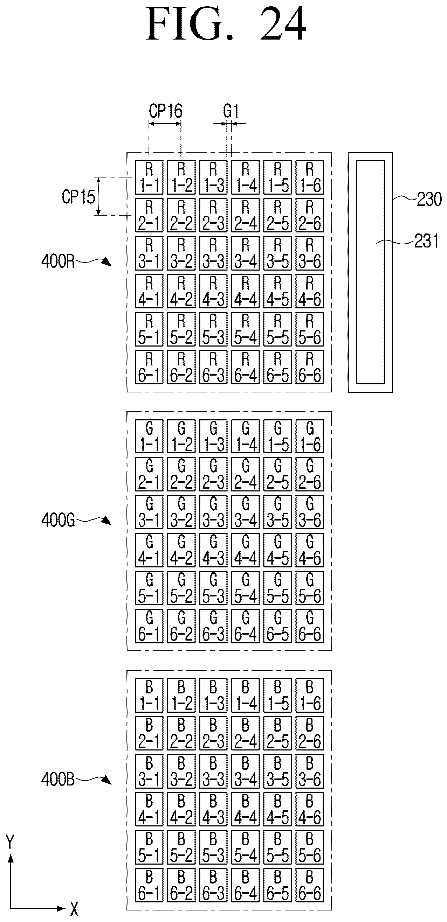

For example, a plurality of red light emitting diodes of the third red transfer substrate 400R may be moved to the fourth red transfer substrate 500R by one column by a laser beam irradiated to the third red transfer substrate 400R through a plurality of slits 231 of a third mask 230 (see FIG. 24). The plurality of slits 231 of the third mask 230 may have a length and a width corresponding to one column of a plurality of red light emitting diodes of the third red transfer substrate 400R.

By the laser transfer, the red light emitting diodes R1-1, R2-1, R3-1, R4-1, R5-1, and R6-1 of the first column of the third red transfer substrate 400R may be simultaneously or nearly simultaneously moved to the fourth red transfer substrate 500R. The red light emitting diodes R1-2, R2-2, R3-2, R4-2, R5-2, and R6-2 of the second column of the third red transfer substrate 400R may be moved from the red light emitting diodes R1-1, R2-1, R3-1, R4-1, R5-1, and R6-1of the first column of the fourth red transfer substrate 500R to the third red transfer substrate 500R to be spaced apart in the second direction (Y-axis direction) at a seventh chip pitch CP17. The seventh chip pitch CP17 may be greater than the sixth chip pitch CP16.

The red light emitting diodes R1-3, R2-3, R3-3, R4-3, R5-3, and R6-3of a third column of the third red transfer substrate 400R may be moved to the fourth red transfer substrate 500R so as to be spaced apart at the sixth chip pitch CP16 on the right side of the red light emitting diodes R1-1, R2-1, R3-1, R4-1, R5-1, and R6-1 in the first column of the fourth red transfer substrate 500R. Then, red light emitting diodes R1-4, R2-4, R3-4, R4-4, R5-4, and R6-4 of a fourth column of the third red transfer substrate 400R are moved to the fourth red transfer substrate 500R to be spaced apart from red light emitting diodes R1-3, R2-3, R3-3, R4-3, R5-3, and R6-3 of a third column of a fourth red transfer substrate 500R at a seventh chip pitch CP17. In this example, the red light emitting diodes (R1-4, R2-4, R3-4, R4-4, R5-4, and R6-4 of the fourth column moved to the fourth red transfer substrate 500R may be spaced apart on the right side of the red light emitting diodes R1-2, R2-2, R3-2, R4-2, R5-2, and R6-2of the second column at a sixth chip pitch CP16.

The red light emitting diodes R1-5, R2-5, R3-5, R4-5, R5-5, and R6-5 of a fifth column of the third red transfer substrate 400R may be moved to the fourth red transfer substrate 500R so as to be spaced apart on the right side of the red light emitting diode R1-3, R2-3, R3-3, R4-3, R5-3, and R6-3 in the third column arranged in the fourth red transfer substrate 500R at a sixth chip pitch CP16. Next, the red light emitting diodes R1-6, R2-6, R3-6, R4-6, R5-6, and R6-6 of a sixth column of the third red transfer substrate 400R are moved to the fourth red transfer substrate 500R on the right side of the red light emitting diodes R1-4, R2-4, R3-4, R4-4, R5-4, and R6-4 in a fourth column arranged on the fourth red transfer substrate 500R at a sixth chip pitch CP16.

A red light emitting diode may be arranged at a second interval G2 by three diodes per row to correspond to a unit pixel of the target substrate 50 in a second direction (X-axis direction) of the fourth red transfer substrate 500R. The red light emitting diodes arranged by three diodes in the second direction (X-axis direction) may be arranged at a first interval G1. The first interval G1 is the same as the interval according to the second direction (X-axis direction) between the red light emitting diodes in the third red transfer substrate 400R.

In the same process as described above, a plurality of green light emitting diodes of the third green transfer substrate 400G and a plurality of blue light emitting diodes of the third blue transfer substrate 400B may be moved to the fourth green transfer substrate 500G and the fourth blue transfer substrate 500B, respectively.

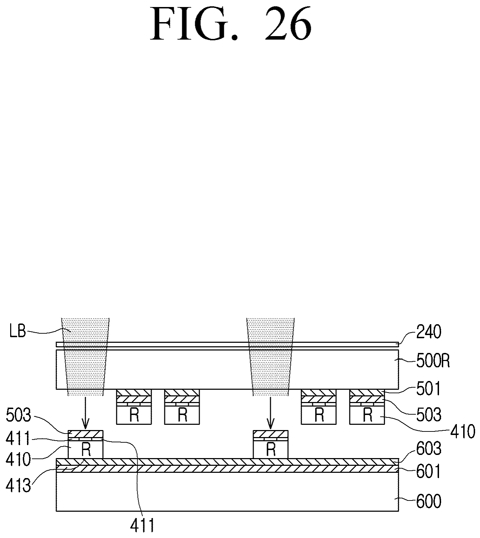

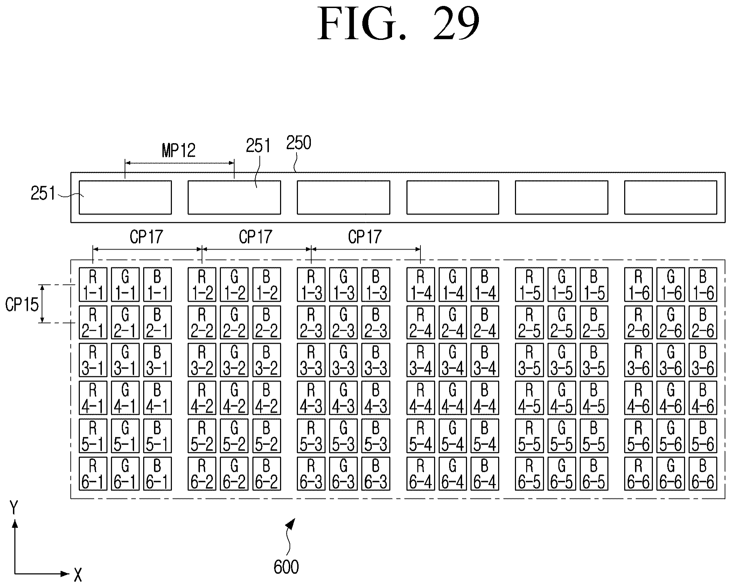

The red, green, and blue light emitting diodes of the fourth transfer substrates, fourth red transfer substrate 500R, fourth green transfer substrate 500G, fourth blue transfer substrate 500B illustrated in FIG. 26 may be moved to one piece of the fifth transfer substrate 600 illustrated in FIG. 29 in a predetermined arrangement by a laser transfer method.

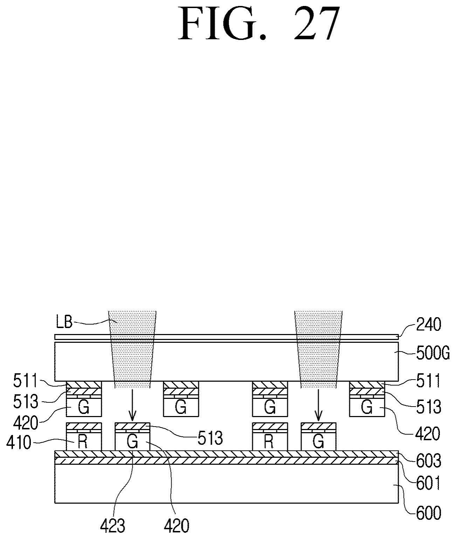

Referring to FIG. 27, a plurality of red light emitting diodes 410 may be moved from the fourth red transfer substrate 500R to the fifth transfer substrate 600. In this example, the fourth red transfer substrate 500R is disposed above the fifth transfer substrate 600, and the light emitting surface 413 of the plurality of red light emitting diodes 410 faces the adhesive layer 603 of the fifth transfer substrate 600. The fourth transfer substrate 600 may include a laser ablation layer 601. An adhesive layer 603 may be stacked on the laser ablation layer 601.

A portion of the laser ablation layer 601 and the adhesive layer 603 of the fourth red transfer substrate 500R that does not correspond to a plurality of red light emitting diodes 410 in the fourth red transfer substrate 500R may be removed by plasma etching. Accordingly, the laser ablation layer 601 and the adhesive layer 603 of the fourth red transfer substrate 500R may be divided into the number corresponding to each of the red light emitting diodes 410.

A method of moving a plurality of red light emitting diodes 410 from the fourth red transfer substrate 500R to the fifth transfer substrate 600 will be described in detail with reference to FIG. 25, FIG. 26, and FIG. 29.

Referring to FIG. 26, a plurality of red light emitting diodes 410 of the fourth red transfer substrate 500R may be moved to the fifth transfer substrate 600 by two diodes by a laser beam LB irradiated onto the fourth red transfer substrate 500R through a pair of slits 241 of a fourth mask 240. A pair of slits 241 of the fourth mask 240 may be formed to have a size corresponding to a single red light emitting diode 410, and a pitch MP11 between the slits 241 may correspond to a seventh chip pitch CP17.

A first light emitting diode R1-1 and a second red light emitting diode R1-2 in a first row of the fourth red transfer substrate 500R may be moved to the fifth transfer substrate 600 so as to be spaced apart at a seventh chip pitch CP17 by a laser transfer method.

A third light emitting diode R1-3 and a fourth red light emitting diode R1-4 in the first row of the fourth red transfer substrate 500R are moved to the first row of the fifth transfer substrate 600. Referring to FIG. 29, the fourth red light emitting diode R1-3 is disposed on the fifth transfer substrate 600 to be spaced apart on a right side of a second red light emitting diode R1-2 of the fifth transfer substrate 600 at a seventh chip pitch CP17. The fourth red light emitting diode R1-4 may be disposed on the fifth transfer substrate 600 while being spaced apart on the right side of the third red light emitting diode R1-3 of the fifth transfer substrate 600 at a seventh chip pitch CP17.

Then, the fifth red light emitting diode R1-5 and the sixth red light emitting diode R1-6 in the first row of the third red transfer substrate 500R may be moved to the fifth transfer substrate 600 in the same manner as the transfer method of the third red light emitting diodes R1-3 and the fourth red light emitting diode R1-4.

As such, after the red light emitting diodes R1-1, R1-2, R1-3, R1-4, R1-5, and R1-6 of the first row of the fourth red transfer substrate 500R are moved to the fifth transfer substrate 600, the remaining red light emitting diodes R2-1, R2-2, R2-3, R2-4, R2-5, R2-6, R3-1, R3-2, R3-3, R3-4, R3-5, R3-6, R4-1, R4-2, R4-3, R4-4, R4-5, R4-6, R5-1, R5-2, R5-3, R5-4, R5-5, R5-6, R6-1, R6-2, R6-3, R6-4, R6-5, and R6-6 of the third red transfer substrate 500R are sequentially moved to the fifth transfer substrate 600 for each row. In this example, the red light emitting diodes R1-1, R1-2, R1-3, R1-4, R1-5, R1-6, R2-1, R2-2, R2-3, R2-4, R2-5, R2-6, R3-1, R3-2, R3-3, R3-4, R3-5, R3-6, R4-1, R4-2, R4-3, R4-4, R4-5, R4-6, R5-1, R5-2, R5-3, R5-4, R5-5, R5-6, R6-1, R6-2, R6-3, R6-4, R6-5, and R6-6moved to the fifth transfer substrate 600 may be disposed to be spaced apart at a fifth chip pitch CP15 between rows.

A plurality of green LEDs of the third green transfer substrate 500G and a plurality of blue LEDs of a third blue transfer substrate 500B are moved to the fourth transfer substrate 600, respectively.

Referring to FIG. 27, in the same manner as described above, a plurality of green light emitting diodes 420 may be moved from the fourth green transfer substrate 500G to the fifth transfer substrate 600. In FIG. 27, reference numeral 423 denotes a light emitting surface of the green light emitting diode 420, 511 denotes a laser ablation layer, and 513 denotes an adhesive layer.

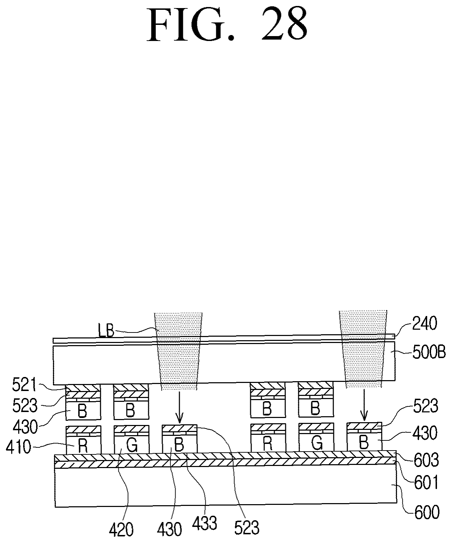

Referring to FIG. 28, in the same manner as described above, a plurality of blue light emitting diodes 430 may be moved from the fourth blue transfer substrate 500G to the fifth transfer substrate 600. In FIG. 28, reference numeral 433 denotes a light emitting surface of the blue light emitting diode 430, 521 denotes a laser ablation layer, and 523 denotes an adhesive layer.

A plurality of red light emitting diodes 410, a plurality of green light emitting diodes 420, and a plurality of blue light emitting diodes 430 arranged in the fifth transfer substrate 600 may be arranged in units of pixels as illustrated in FIG. 29. One pixel may include a red light emitting diode 410, a green light emitting diode 420, and a blue light emitting diode 430. In this example, each light emitting diode may be referred to as a subpixel.

The plurality of red light emitting diodes 410, the plurality of green light emitting diodes 420, and the plurality of blue light emitting diodes 430 arranged in the fifth transfer substrate 600 may be maintained without removing the adhesive layer 503, adhesive layer 513, and adhesive layer 523 covering the first electrode 411, the first electrode 421, the first electrode 431 and the second electrode 412, the second electrode 422, and the second electrode 423, respectively. Therefore, the plurality of adhesive layers, the adhesive layer 503, the adhesive layer 513, and the adhesive layer 523, may be removed from the plurality of red light emitting diodes 410, the plurality of green light emitting diodes 420, and the plurality of blue light emitting diodes 430 by an etching process.

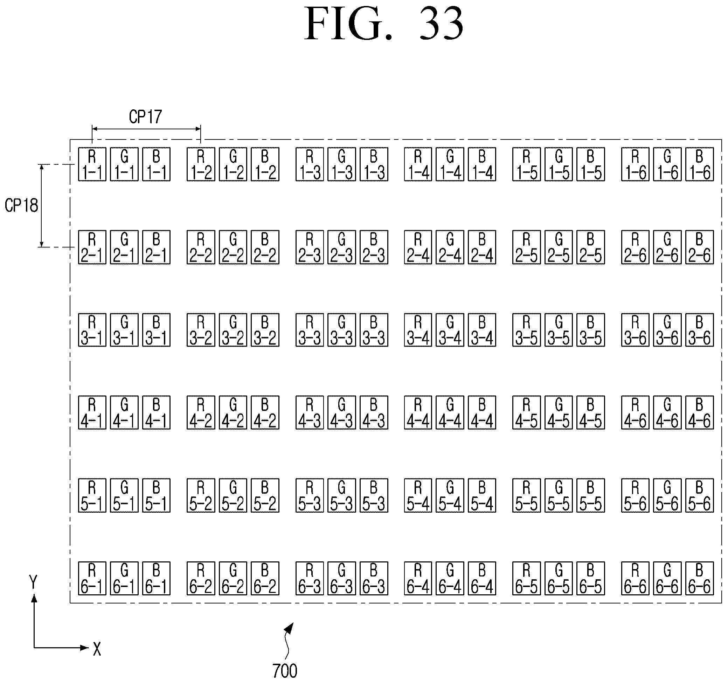

A plurality of red, green, and blue light emitting diodes of the fifth transfer substrate 600 illustrated in FIG. 29 may be transferred to the target substrate 700 by a laser transfer method. In this example, the plurality of red, green, and blue light emitting diodes may be arrayed in a stretched manner to be spaced in a first direction (Y-axis direction) on the target substrate 700 as illustrated in FIG. 33.

A method of moving a plurality of red, green, and blue light emitting diodes 410, 420, 430 from the fifth transfer substrate 600 to the target substrate 700 will be described in detail with reference to FIG. 29, FIG. 30, FIG. 31, FIG. 32, and FIG. 33.

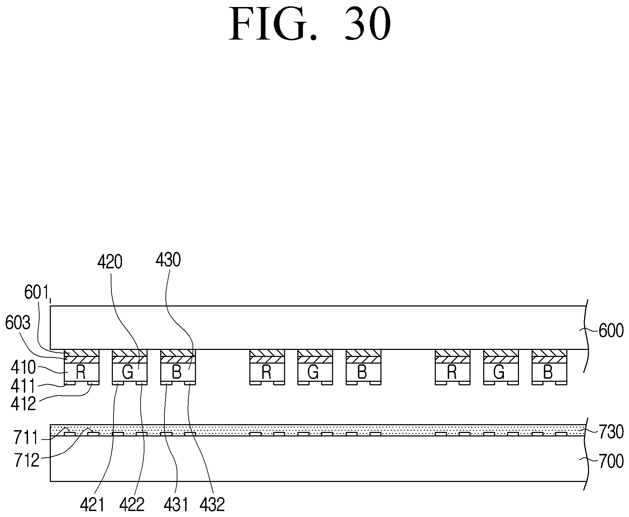

Referring to FIG. 30, the fifth transfer substrate 600 is aligned with a target substrate 700. In this example, the plurality of the red light emitting diode 410, the green light emitting diode 420, and the blue light emitting diode 430 of the fifth transfer substrate 600 may be arranged such that the first electrode 411, the first electrode 421, and the first electrode 431 and the second electrode 412, the second electrode 422, and the second electrode 432 face the target substrate 700.

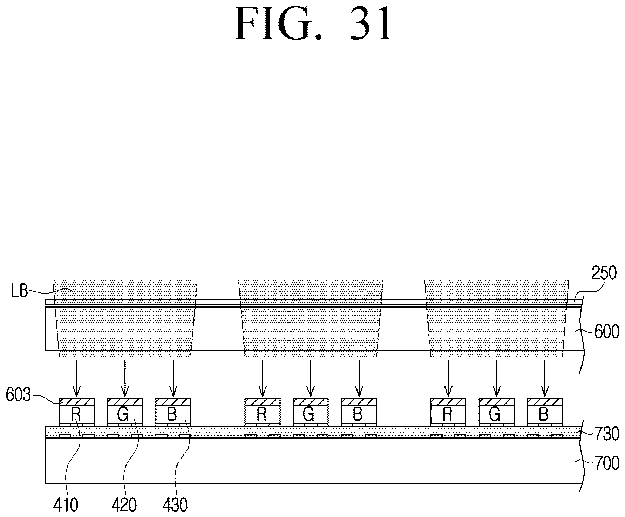

Referring to FIG. 31, a plurality of the red light emitting diode 410, the green light emitting diode 420, and the blue light emitting diode 430 of the fifth transfer substrate 600 may be moved to the target substrate 700 by one row by a laser beam LB irradiated to the fifth transfer substrate 600 through a plurality of slits 251 of the fifth mask 250. Each slit 251 of the fifth mask 250 may be spaced apart to correspond to the seventh chip pitch CP17 in a row direction. Each slit 251 of the fifth mask 250 may have a length and a width corresponding to one pixel (three light emitting diodes of red, green, and blue).

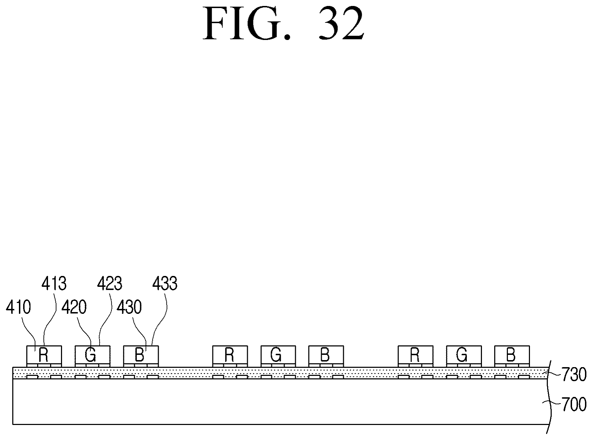

Referring to FIG. 32, a plurality of the red light emitting diode 410, the green light emitting diode 420, and the blue light emitting diode 430 in the first row of the fifth transfer substrate 600 may be simultaneously or nearly simultaneously moved to the target substrate 700 to be spaced apart at a seventh chip pitch CP17 by a laser transfer method.

Referring to FIG. 33, a plurality of the red light emitting diode 410, the green light emitting diode 420, and the blue light emitting diode 430 of the second row of the fifth transfer substrate 600 may be moved to the target substrate 700 to be spaced apart from multicolor LEDs in a first row of the target substrate 700 at an eighth chip pitch DP18 in a column direction. In the same manner, the plurality of the red light emitting diode 410, the green light emitting diode 420, and the blue light emitting diode 430 of the remaining third to sixth rows of the fifth transfer substrate 600 may be moved to the target substrate 700 to have an eighth chip pitch DP18 in the second direction, respectively.

After all of the plurality of the red light emitting diode 410, the green light emitting diode 420, and the blue light emitting diode 430 are transferred from the fifth transfer substrate 600 to the target substrate 700, the adhesive layer 603 remaining on the light emitting surface 413, the light emitting surface 423, and the light emitting surface 433 of each of the red light emitting diode 410, the green light emitting diode 420, and the blue light emitting diode 430 may be removed through an etching process.

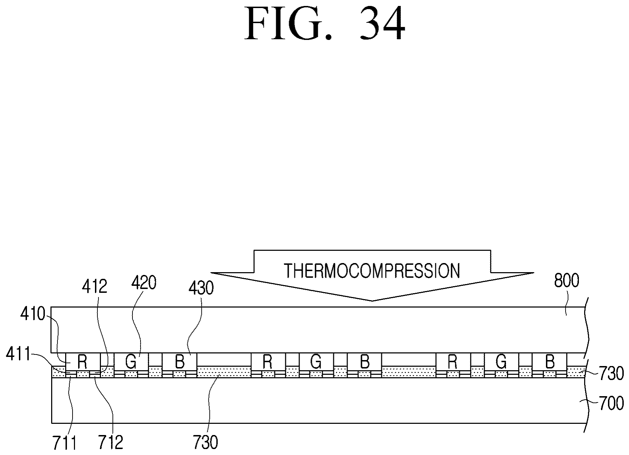

Referring to FIG. 34, when a plurality of the red light emitting diode 410, the green light emitting diode 420, and the blue light emitting diode 430 of the fifth transfer substrate 600 are all moved to the target substrate 700 by a laser transfer method, light emitting surface 413, light emitting surface 423, and light emitting surface 433 of a plurality of the red light emitting diode 410, the green light emitting diode 420, and the blue light emitting diode 430 arranged on the target substrate 700 are pressed by using a pressing member 800.

The pressing member 800 may include a heater therein, and a heater may also be provided in a stage in which the target substrate 700 is fixedly disposed. Each heater heats the target substrate 700 during thermocompression. In this example, the heating temperature is preferably within a temperature range to the extent that the target substrate 700 is not degraded.

By thermocompression, a plurality of the red light emitting diode 410, the green light emitting diode 420, and the blue light emitting diode 430 of the target substrate 700 may be electrically connected to a first substrate pad 711 and a second substrate pad 712 corresponding to the first electrode 411, first electrode 421, and first electrode 431 and the second electrode 412, second electrode 422, second electrode 432, respectively. In addition, the plurality of the red light emitting diode 410, the green light emitting diode 420, and the blue light emitting diode 430 may be physically and firmly fixed to the conductive adhesive layer 730.

As described above, according to the method for manufacturing a display panel according to one or more embodiments, when a light emitting diode is transferred from a transfer substrate to another transfer substrate (or a target substrate) by laser transfer, a plurality of light emitting diodes may be transferred while moving at a constant speed without fixing another transfer substrate (or target substrate) and thus, the time required for laser transfer may be shortened.

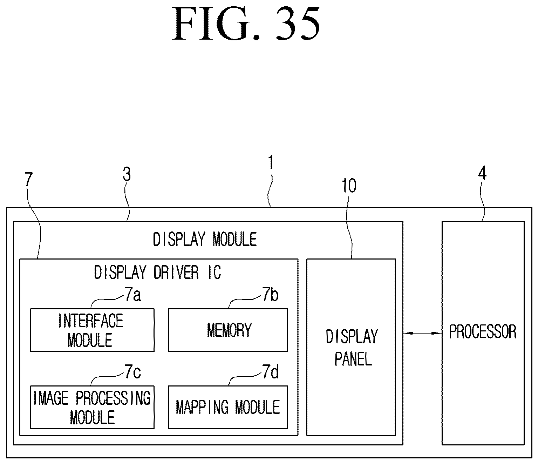

FIG. 35 is a block diagram illustrating a display device according to one or more embodiments.

Referring to FIG. 35, the display device 1 may include the display module 3 and the processor 4. The display module 3 may include a display panel 10 and a display driver integrated circuit (IC) 7 for controlling the display panel 10.

The processor 4 may be implemented with a Digital Signal Processor (DSP) for processing of a digital signal, a microprocessor, a Time Controller (TCON), or the like. The processor 5 may include one or more among a Central Processor (CPU), a Micro Controller Unit (MCU), a Micro Processor Unit (MPU), a controller, an application processor (AP), a Communication Processor (CP), an Advanced Reduced instruction set computing machine (ARM) processor, a dedicated processor, or may be defined as a corresponding term. The processor 4 may be implemented in a System-on-Chip (SoC) type or a Large Scale Integration (LSI) type which a processing algorithm is built therein, Application Specific Integrated Circuit (ASIC), or in a Field Programmable Gate Array (FPGA) type.

The processor 4 may drive an operating system or an application program to control hardware or software components connected to the processor 4, and may process and compute a variety of data. In addition, the processor 4 may load, in a volatile memory, instructions or data received from at least one of the other components, process the loaded instructions or data, and store various data in the non-volatile memory.

The display driver IC 7 includes an interface module 7a, a memory 7b (e.g., a buffer memory), an image processing module 7c, and a mapping module 7d. The display driver IC 7 may receive image information including image data, or an image control signal corresponding to a command for controlling the image data from another component of the display apparatus 1 through the interface module 7a. For example, according to an embodiment, the image information may be received from the processor 4 (e.g., a main processor, an Application Processor (AP)) or the secondary processor (e.g., a Graphic Processing Unit (GPU)) operating independently of the function of the main processor.

In addition, the display driver IC 7 may store at least a part of the received image information in the memory 7b, for example, in a frame unit. The image processing module 7c may perform pre-processing or post-processing (e.g., resolution, brightness, or size adjustment) for at least a part of the image data based on at least one of the characteristics of the image data or characteristics of the display panel 10. The mapping module 7d may generate a voltage value or a current value corresponding to the image data pre-processed or post-processed through the image processing module 7c. The generation of a voltage value or current value may be performed based at least in part on an attribute of pixels of the display panel 10 (e.g., an array of pixels (an RGB stripe or a PenTile structure), or a size of each of the subpixels). At least some pixels of the display panel 10 may be driven based at least in part on the voltage value or current value such that visual information (e.g., text, an image, or an icon) corresponding to the image data may be displayed through the display panel 10.

The display deriver IC 7 may transmit a driving signal (e.g., a driver driving signal, a gate driving signal, etc.) to a display based on image information received from the processor 4.

The display driver IC 7 may display an image based on the image signal received from the processor 4. For example, the display driver IC 7 may generate a driving signal of a plurality of sub-pixels based on an image signal received from the processor 4, and display an image by controlling light emissions of the plurality of sub-pixels based on the driving signal.

According to one or more embodiments, the display module 3 may further include a touch circuit. The touch circuit may include a touch sensor and a touch sensor IC for controlling the same. The touch sensor IC may control the touch sensor to detect a touch input or hovering input for the designated location of the display panel 10. For example, the touch sensor IC may detect a touch input or hovering input by measuring the change in the signal (e.g., voltage, light amount, resistance, or charge) for the designated location of the display panel 10. For example, the touch sensor IC may provide information about the detected touch input or hovering input (e.g., location, area, pressure, or time) to the processor 4. According to an embodiment, at least part of the touch circuit (e.g., the touch sensor IC) may be included as part of the display driver IC 7, or as part of the display panel 10, or other components (e.g., a sub-processor) placed outside of the display module 3.

According to one or more embodiments, the pixel driving method of the display module 3 may be an active matrix (AM) driving method or a passive matrix (PM) driving method.

According to one or more embodiments, the display device 1 may include the display module 3. The display module 3 may display various images. Here, the image may include a still image and/or a moving image. The display module 3 may display various images such as broadcast content, multimedia content, and the like. In addition, the display module 3 may display a user interface and an icon.

According to one or more embodiments, the display module 3 may be installed and applied to wearable devices, portable devices, handheld devices, and electronic products or electronic parts requiring various displays.

According to one or more embodiments, the display device 1 may include a plurality of display modules 3. The plurality of display modules 3 may be physically connected to implement a large format display (e.g., a large format display). The large display may be a monitor for a personal computer, a high-resolution television, a signage (or a digital signage) or an electronic display by connecting a plurality of display modules in a grid array.

Although the disclosure is illustrated and described with reference to various examples, it will be understood by one of ordinary skill in the art that various changes may be made in form and detail without departing from the spirit and scope of the disclosure defined by the appended claims and their equivalents.

## Claims

1. A transfer substrate comprising:
a substrate;
a laser ablation layer provided on the substrate; and
an adhesive layer provided on the laser ablation layer and comprising a plurality of light emitting diodes,
wherein the laser ablation layer and the adhesive layer are divided into a plurality of portions each comprising ones of the plurality of light emitting diodes.

2. The transfer substrate of claim 1, wherein the substrate is configured to transmit a laser beam.

3. A light emitting diode transfer method comprising:
transferring a plurality of light emitting diodes from a wafer to a first transfer substrate on which a first laser ablation layer and a first adhesive layer are stacked;
removing first exposed portions of the first laser ablation layer and the first adhesive layer, the first exposed portions being exposed between the plurality of light emitting diodes;
transferring the plurality of light emitting diodes from the first transfer substrate to a second transfer substrate on which a second laser ablation layer and a second adhesive layer are stacked;
removing second exposed portions of the second laser ablation layer and the second adhesive layer, the second exposed portions being exposed between the plurality of light emitting diodes; and
transferring the plurality of light emitting diodes from the second transfer substrate to a target substrate.

4. The light emitting diode transfer method of claim 3, wherein removing the first exposed portions of the first laser ablation layer and the first adhesive layer exposed between the plurality of light emitting diodes comprises removing the first exposed portions by a plasma etching process.

5. The light emitting diode transfer method of claim 3, wherein removing the second exposed portions of the second laser ablation layer and the second adhesive layer exposed between the plurality of light emitting diodes comprises removing the second exposed portions by a plasma etching process.

6. The light emitting diode transfer method of claim 3, wherein removing the first exposed portions of the first laser ablation layer and the first adhesive layer comprises removing the first laser ablation layer by laser beam and removing the first adhesive layer by a plasma etching process.

7. The light emitting diode transfer method of claim 3, wherein removing the second exposed portions of the second laser ablation layer and the second adhesive layer comprises removing the second laser ablation layer by laser beam and removing the second adhesive layer by a plasma etching process.

8. The light emitting diode transfer method of claim 3, wherein the plurality of light emitting diodes transferred from the first transfer substrate to the second transfer substrate are arranged with a first distance between each other in a first direction.

9. The light emitting diode transfer method of claim 8, wherein the plurality of light emitting diodes transferred from the first transfer substrate to the second transfer substrate are arranged in a grid in the second transfer substrate, and
wherein the grid comprises a plurality of rows and a predetermined interval between each of the plurality of rows.

10. The light emitting diode transfer method of claim 8, wherein the plurality of light emitting diodes transferred from the second transfer substrate to the target substrate are arranged with a second distance between each other in a second direction perpendicular to the first direction.

11. The light emitting diode transfer method of claim 10, wherein the plurality of light emitting diodes transferred from the second transfer substrate to the target substrate are arranged in a grid in the target substrate, and
wherein the grid comprises a plurality of columns and a predetermined interval between each of the columns.

12. A light emitting diode transfer method comprising:
transferring a plurality of light emitting diodes from a wafer to a first transfer substrate, wherein the plurality of light emitting diodes are arranged in a grid on the first transfer substrate;
transferring, from the first transfer substrate to a second transfer substrate, the plurality of light emitting diodes at first predetermined intervals in a first direction; and
transferring, from the second transfer substrate to a target substrate, the plurality of light emitting diodes at second predetermined intervals in a second direction perpendicular to the first direction.

13. The light emitting diode transfer method of claim 12,
wherein the grid comprises a plurality of rows and a plurality of columns,
wherein an arrangement of the plurality of light emitting diodes on the first transfer substrate comprises a first chip pitch, between the plurality of rows, and a second chip pitch between the plurality of columns,
wherein the plurality of light emitting diodes arranged on the second transfer substrate are arranged with a third chip pitch between the plurality of rows, and
wherein the third chip pitch is greater than the first chip pitch.

14. The light emitting diode transfer method of claim 13, wherein transferring, from the second transfer substrate to the target substrate, the plurality of light emitting diodes comprises arranging the plurality of light emitting diodes in the target substrate in rows having a fourth chip pitch therebetween,
wherein the fourth chip pitch is greater than the second chip pitch.

15. The light emitting diode transfer method of claim 13, wherein transferring, from the first transfer substrate to a second transfer substrate, the plurality of light emitting diodes comprises arranging the plurality of light emitting diodes in the second transfer substrate in rows with the second chip pitch therebetween.
